# EUROPÄISCHE PATENTSCHRIFT

(11) **EP 2 733 718 B1**
(45) Veröffentlichungstag und Bekanntmachung des Hinweises auf die Patenterteilung: **01.01.2025**
(21) Anmeldenummer: 13005266.5
(22) Anmeldetag: 08.11.2013
(51) Int. Cl.: H01H 47/00, G05B 9/02, G01R 31/327, G01R 31/28, G01R 31/50

(54) **VERFAHREN UND VORRICHTUNG ZUR AUSWERTUNG VON SIGNALEN, DIE VON EINEM OSSD-AUSGANGSELEMENT KOMMEN**
Method and device for evaluating signals from an OSSD output element
Procédé et dispositif d'évaluation de signaux provenant d'un élément de sortie OSSD

(30) Priorität: 16.11.2012 DE 102012022397
(43) Veröffentlichungstag der Anmeldung: 21.05.2014
(73) Patentinhaber: Phoenix Contact GmbH & Co. KG, 32825 Blomberg (DE)
(72) Erfinder: Oster, Viktor, 32825 Blomberg (DE)
(74) Vertreter: Blumbach · Zinngrebe Patentanwälte PartG mbB

(56) Entgegenhaltungen:
- EP-A2- 0 864 875
- WO-A1-01/48570
- WO-A1-2007/014725
- WO-A1-2011/061345
- WO-A2-03/085313
- DE-A1- 19 805 722
- DE-B3- 102005 055 325

## Beschreibung

Die Erfindung betrifft ein Verfahren und eine Schaltung zur Auswertung von Signalen, die von einem OSSD-Ausgangsschaltelement kommen.

zur Reduzierung eines Risikos für Mensch oder Umwelt werden insbesondere in automatisierten Anlagen Sicherheitsfunktionen realisiert. Einfache Beispiele hierfür sind die Abschaltung einer Maschine nach Drücken eines Not-Aus-Tasters oder das Anhalten eines Roboters, wenn eine Person in den Sicherheitsbereich des Roboters eintritt und dabei z.B. eine Lichtschranke unterbricht oder von einem ein Lichtgitter erfasst wird, welches den Sicherheitsbereich des Roboters überwacht oder eine überwachte Zugangstür öffnet. Bei besonders sicherheitskritischen Prozessen kann es auch erforderlich sein, größere Teile einer komplexen Anlage oder sogar die gesamte Anlage herunter zu fahren, wenn bestimmte Sicherheitsfunktionen aktiviert werden.

Hierfür wird sicherheitsgerichtete Technik bzw. Sicherheitstechnik eingesetzt. Im Allgemeinen realisiert die Anwendung von Sicherheitstechnik einerseits die eigentliche Sicherheitsfunktion wie z.B. Not-Aus-Schaltung, Zweihand-Schaltung, Betriebsartenwahlschalter etc., zum anderen umfasst die Sicherheitstechnik fehlererkennende und/oder fehlerbeherrschende Maßnahmen z.B. nach in Standards festgelegten Sicherheitsanforderungen (z.B. nach IEC 61508, ISO 13849 etc.). Diese Sicherheitsanforderungen sind dem Fachmann grundsätzlich bekannt.

Innerhalb der Sicherheitstechnik zu deren Umsetzung eingesetzte Geräte und/oder Signale, welche den Sicherheitsanforderungen entsprechen, werden im Rahmen der Erfindung als sichere Geräte bzw. sichere Signale bezeichnet.

Insbesondere im Bereich der Sicherheitstechnik werden oft auch OSSD-Ausgangsschaltelemente (OSSD, Output Signal Switching Device) benötigt, die interne Ausgangsschaltkreise beinhalten, die entsprechend der Sicherheitsanforderungen getestet werden müssen.

Die Diagnose der Abschaltfähigkeit der Ausgangsschaltkreise erfolgt in der Regel durch kurzes Abschalten der diesen zugeordneten Ausgangstreibern. Die hierbei verwendeten Abschaltimpulse sind jedoch an den, die jeweiligen Ausgangsschaltkreise abschließenden Ausgangsklemmen sichtbar. Möchte man die Ausgänge von OSSD-Ausgangsschaltelementen, nachfolgend als OSSD-Ausgänge bezeichnet, daher an die Eingänge von Eingangsgeräten anschließen, entsteht folglich, insbesondere im Falle von sicheren Eingangsgeräten, die Notwendigkeit, dass diese sichtbaren Abschaltimpulse durch einen Eingangsfilter des Eingangsgerätes kommen und aufgrund der Sichtbarkeit ausgefiltert werden müssen.

Typische sichere Eingangsgeräte verwenden nach heutigem Stand der Technik in der Regel ferner eigene Testausgänge zur Überwachung einer externen Verkabelung. Dabei werden Testimpulse der Testausgänge wiederum in den Eingangsgeräten erfasst. Sollten diese ausbleiben, bedeutet das, dass ein Querschluss in der Verkabelung vorliegt und die Eingangsgeräte entsprechend reagieren müssen, und also insbesondere in dem Fall von sicheren Eingangsgeräten einen sicheren Zustand einnehmen müssen.

Wenn die Eingänge der Eingangsgeräte mit den OSSD-Ausgängen verbunden werden, kann das Eingangsgerät keine Überprüfung der Verdrahtung über die eigenen Testausgänge vornehmen, da diese nicht mit den OSSD-Ausgängen verschaltbar sind. Das heißt, die Eingangsgeräte haben keine Diagnose über die Verkabelung, was in vielen Applikationen nicht zulässig ist. Es bleibt dann nur zu hoffen, dass die Diagnose der OSSD-Ausgänge ausreicht und diese im Fehlerfall einen vorbestimmten, insbesondere sicheren Zustand einnehmen. Dies ist z.B. bei einem Querschluss zu 24V nicht möglich, da die OSSD-Ausgänge in diesem Fehlerfall überbrückt sind. Bei vielen Applikationen muss deswegen dieser Fehlerfall durch eine sichere Verkabelung der Leitungen ausgeschlossen werden, was zusätzlich auch für erhöhte Kosten verursacht.

Aus der DE 10 2010 062 310 A1 ist beispielsweise eine Schaltung bekannt, die die Aufgabe hat, einen Bruch in der Zuleitung oder einen Kurzschluss zu Masse oder zu 24V zu erkennen und welche hierfür einen Taktausgang benötigt, der für die Sicherheitstechnik untypisch ist, da die typischen OSSD-Ausgänge sehr unterschiedlich in der Taktung sind. Alleine aus dem Takt kann darüber hinaus keine Information für den Status eines OSSD-Ausgangs gewonnen werden. Deswegen ist eine solche Lösung nur auf spezielle Ausgangsgeräte eingeschränkt, die im aktiven Zustand ein wechselndes Signal erzeugen.

WO 2007/014725 A1 beschreibt eine Sicherheitsschaltgerät zum Steuern einer sicherheitstechnischen Einrichtung in einen sicheren Zustand. Hierbei weist die Sicherheitseinrichtung eine erste Steuereinheit auf, die als programmierbare Steuereinheit ausgebildet ist und eine Einrichtung zum Erzeugen eines Überwachungssignals aufweist. Ferner weist die Sicherheitseinrichtung eine zweite Steuereinrichtung auf, wobei eine Eingangsstufe des Sicherheitsschaltgerätes mit der ersten und der zweiten Steuereinrichtung verbunden ist. Ferner ist die Eingangsstufe zum Modulieren eines Eingangssignals mit einem von der ersten Steuereinrichtung kommenden Überwachungssignal ausgebildet.

DE 198 05 722 A1 beschreibt ein Verfahren und eine Vorrichtung zur Überwachung von elektrischen Leitungen, insbesondere zur Überwachung von Kurzschlüssen. Hierbei kann eine Überwachung von OSSD-Leitungen (Output-Safety-Switching-Device-Leitungen) erfolgen, wobei Querschlüsse zwischen den Leitungen erkannt werden.

WO 03/085313 A2 betrifft eine Vorrichtung zum fehlersicheren Abschalten eines elektrischen Verbrauchers. Sie besitzt ein erstes und zumindest ein zweites Sicherheitsschaltgerät. Das erste Sicherheitsschaltgerät weist eine erste Auswerte- und Steuereinheit, einen Ausgang und ein elektronisches Schaltelement auf, das in Abhängigkeit von der ersten Auswerte- und Steuereinheit ein potentialbezogenes Schaltsignal an dem Ausgang erzeugt. Das zweite Sicherheitsschaltgerät weist eine zweite Auswerte- und Steuereinheit sowie einen Eingang auf, der mit der zweiten Auswerte- und Steuereinheit und mit dem Ausgang des ersten Sicherheitsschaltgerätes verbunden ist. Das erste und das zweite Sicherheitsschaltgerät sind hier über eine einkanalige Verbindungsleitung miteinander verbunden und das zweite Sicherheitsschaltgerät weist zumindest zwei Eingangskreise auf, denen das potentialbezogene Schaltsignal des ersten Sicherheitsschaltgerätes redundant zueinander zugeführt ist. 1

Eine Aufgabe der Erfindung ist es daher, einen gegenüber dem aufgezeigten Stand der Technik verbesserten Weg aufzuzeigen, mit welchem eine effektive Überwachung auf Fehler in der Verkabelung für den Fall bereitgestellt werden kann, wenn Eingänge von Schaltungsanordnungen, insbesondere von sicheren Eingangsgeräten, mit OSSD-Ausgängen zu verbinden sind.

Die Lösung der Erfindung ist mit einem Gegenstand mit den Merkmalen nach einem der unabhängigen Ansprüche gegeben. Bevorzugte oder zweckmäßige Ausführungsformen und Weiterbildungen sind Gegenstand der Unteransprüche.

Die Erfindung schlägt demgemäß ein Verfahren zur Auswertung von Signalen, die von einem OSSD-Ausgangsschaltelement kommen, vor, bei welchem die statischen und dynamischen Signalanteile von, von einem OSSD-Ausgangsschaltelement kommenden Signalen separat erfasst werden und anschließend ausgewertet werden.

Entsprechend schlägt die Erfindung ferner eine insbesondere zur Durchführung des Verfahrens ausgebildete Vorrichtung vor, die zur Auswertung von Signalen, die von einem OSSD-Ausgangsschaltelement kommen, eine erste Schaltungsanordnung besitzt, welche mit deren Schaltungseingang an den Ausgang eines OSSD-Ausgangsschaltelement anzuschalten ist, wobei die erste Schaltungsanordnung eine Filtereinrichtung besitzt, die ausgebildet ist, statische Signalanteile zu erfassen und dynamische Signalanteile auszufiltern, und eine zweite Schaltungsanordnung besitzt, welche mit deren Schaltungseingang parallel zur ersten Schaltungsanordnung gleichermaßen an den Ausgang des OSSD-Ausgangsschaltelement anzuschalten ist, wobei die zweite Schaltungsanordnung eine Filtereinrichtung besitzt, die ausgebildet ist, dynamische Signalanteile zu erfassen und statische Signalanteile auszufiltern. Die erfindungsgemäße Schaltung besitzt ferner eine Logikvorrichtung, wobei der Schaltungsausgang der ersten Schaltungsanordnung und der Schaltungsausgang der zweiten Schaltungsanordnung mit der Logikvorrichtung verbunden ist, und wobei die Logikvorrichtung ausgebildet ist, die von der ersten Schaltungsanordnung erfassten statischen Signalanteile und die von der zweiten Schaltungsanordnung erfassten dynamischen Signalanteile auszuwerten.

Durch die separate Erfassung sowohl der statischen und dynamischen Signalanteile von Signalen, die von einem OSSD-Ausgangsschaltelement kommen, und deren anschließenden Auswertung, den Signals separat erfasst werden und anschließend ausgewertet werden, ermöglich die Erfindung die Überwachung der Verkabelung, ohne dass spezielle Testimpulse von den Schaltungsanordnungen, insbesondere innerhalb von sicheren Eingangsgeräten, insbesondere über eigene Test- und/oder Taktausgänge erforderlich sind. Falls die Überwachung der Verkabelung der Schaltungsanordnungen, insbesondere innerhalb von sicheren Eingangsgeräten in der Applikation zwingend erfordert ist, wäre es in einer Standardlösung nur mittels kontaktbehafteter Entkopplung der OSSD-Ausgänge von den Schaltungsanordnungen, z.B. über ein Sicherheitsrelais, und der Verwendung zusätzlicher Test- und/oder Taktausgänge möglich. Bei Verwendung der vorgeschlagenen Schaltung kann diese Entkopplung entfallen, da auch eine Querschlussüberwachung durch die Erfassung dynamischer Signalanteile, und folglich durch die Erfassung von dynamischen OSSD-Impulsen vorhanden ist.

Von Vorteil ist ferner, dass die Filtereinrichtung der ersten Schaltungsanordnung aus Hardwareelementen aufgebaut ist oder softwarebasiert aufgebaut sein kann, so dass eine hohe Flexibilität bei der Auslegung der Filtereinrichtung vorhanden ist und also anwendungsspezifisch eine einstellbare Filterzeit zur Ausfilterung von OSSD-Impulsen zur Erfassung der statischen Signalzustände in der ersten Schaltungsanordnung ermöglicht.

Gemäß einer zweckmäßigen Ausführungsform besitzt die zweite Schaltungsanordnung ferner einen Spannungsteiler zur Signalanpassung eines am Schaltungseingang der zweiten Schaltungsanordnung anliegenden Signals.

Gemäß einer zweckmäßigen Ausführungsform besitzt die zweite Schaltungsanordnung einen Kondensator zum Ausfiltern der statischen Signalanteile und einen Optokoppler zur Übertragung von dynamischen Signalanteilen in Richtung der Logikvorrichtung, wobei bevorzugt zwischen dem Optokoppler und der Logikvorrichtung eine Signalanpassungseinrichtung angeordnet ist, die zur Signalanpassung eines von dem Optokoppler erhaltenen Signals ausgebildet ist.

Gemäß einer bevorzugten Ausführungsform ist die erste und die zweite Schaltungsanordnung Teil eines gemeinsamen Eingangsgerätes.

Gemäß einer weiteren bevorzugten Ausführungsform ist die erste Schaltungsanordnung Teil eines Eingangsgerätes und die zweite Schaltungsanordnung Teil eines zum Eingangsgerät parallel geschalteten zweiten Gerätes, insbesondere eines Klemmengerätes, z.B. einer Diagnoseklemme, welches sehr einfach nachträglich installiert werden kann und eine Sicherheitsfunktion der ersten Schaltungsanordnung nicht beeinflusst und darüber hinaus sich z.B. auch selbst aus OSSD-Ausgangssignalen mit Energie versorgen kann, was den Verkabelungsaufwand noch weiter reduziert.

Weitere Merkmale und Vorteile der Erfindung werden aus der nachfolgenden, lediglich als beispielhaft zu betrachtenden Beschreibung von bevorzugten Ausführungsformen unter Bezugnahme auf den beigefügten Zeichnungen ersichtlich, wobei in den Zeichnungen zeigen:
Fig. 1 ein beispielhafter, im Rahmen der Erfindung liegender Aufbau eines Eingangsgerätes mit einer bevorzugten Ausführungsform einer Vorrichtung zur Signalerfassung und zur dynamischen Überwachung von Testimpulsen an OSSD-Ausgängen, und
Fig. 2 eine zur Fig. 1 alternative, weitere bevorzugte Ausführungsform, basierend auf einer Realisierung mittels einer Diagnoseklemme in Kombination mit einem Eingangsgerät.

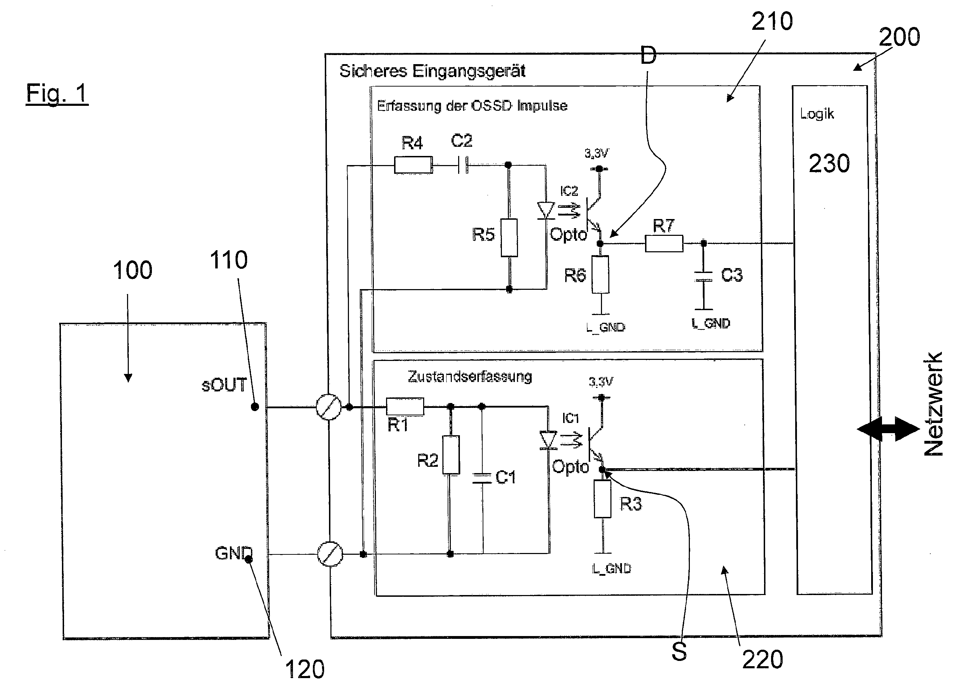

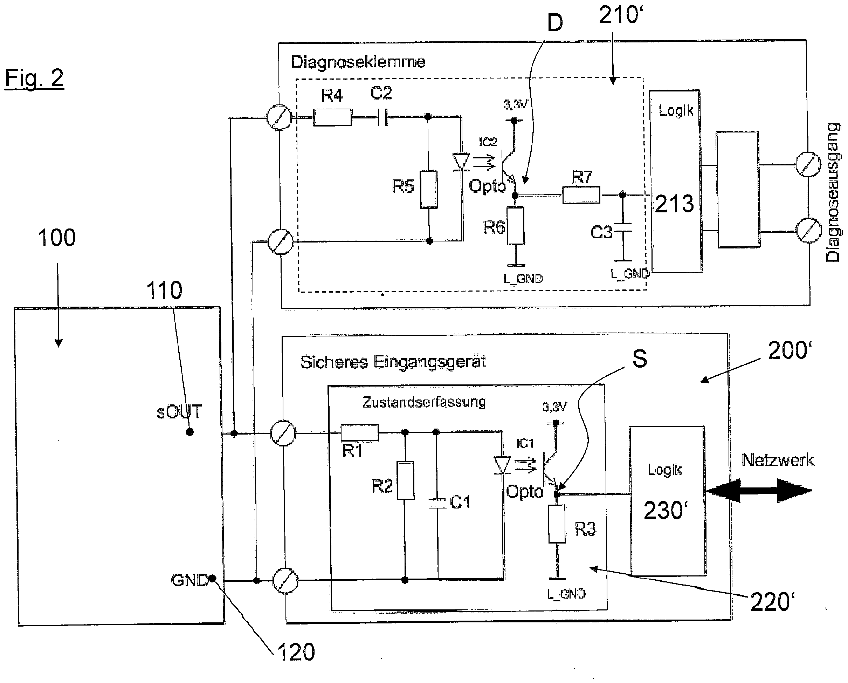

Nachfolgend wird auf die Fig. 1 und 2 Bezug genommen, welche zwei bevorzugte Ausführungsformen der Erfindung darstellen, mit welchen zur Auswertung von Signalen, die von einem OSSD-Ausgangsschaltelement 100 kommen, zunächst statische und dynamische Signalanteile von, von dem OSSD-Ausgangsschaltelement kommenden Signalen separat erfasst werden und anschließend erfasste statischen Signalanteile sowie erfasste dynamische Signalanteile ausgewertet werden können.

Hierzu umfasst jede der Vorrichtungen gemäß der Ausführungsformen nach Fig. 1 und 2 zur Auswertung von Signalen, die von einem OSSD-Ausgangsschaltelement 100) kommen, jeweils eine erste Schaltungsanordnung 220 (Fig. 1) bzw. 220' (Fig. 2), welche mit deren Schaltungseingang an den Ausgang 110, 120 des OSSD-Ausgangsschaltelement 100 anzuschalten ist bzw. im dargestellten Zustand bereits angeschaltet ist. Die erste Schaltungsanordnung besitzt jeweils eine Filtereinrichtung, die ausgebildet ist, statische Signalanteile zu erfassen und dynamische Signalanteile auszufiltern. Diese erste Schaltungsanordnung 220 (Fig. 1) bzw. 220' (Fig. 2) kann folglich einen statischen Zustand erfassen.

Ferner umfasst jede der Vorrichtungen jeweils eine zweite Schaltungsanordnung 210 (Fig. 1) bzw. 210' (Fig. 2), welche mit deren Schaltungseingang parallel zur ersten Schaltungsanordnung gleichermaßen an den Ausgang 110, 120 des OSSD-Ausgangsschaltelement 100 anzuschalten ist bzw. im dargestellten Zustand bereits angeschaltet ist. Die zweite Schaltungsanordnung besitzt jeweils eine Filtereinrichtung, die ausgebildet ist, dynamische Signalanteile zu erfassen und statische Signalanteile auszufiltern. Diese zweite Schaltungsanordnung 210 (Fig. 1) bzw. 210' (Fig. 2) kann folglich OSSD-Impulse erfassen.

Ferner umfasst jede der Vorrichtungen eine Logikvorrichtung 230 (Fig. 1) bzw. 213, 230' (Fig.2), mit welcher der Schaltungsausgang der ersten Schaltungsanordnung und der Schaltungsausgang der zweiten Schaltungsanordnung verbunden ist, und die ausgebildet ist, die von der ersten Schaltungsanordnung erfassten statischen Signalanteile und die von der zweiten Schaltungsanordnung erfassten dynamischen Signalanteile auszuwerten.

Gemäß Ausführungsform nach Fig. 1 sind die erste Schaltungsanordnung 220 und die zweite Schaltungsanordnung 210 Teile eines gemeinsamen Eingangsgerätes 200, insbesondere eines sicheren Eingangsgerätes.

Gemäß Ausführungsform nach Fig. 2 ist lediglich die erste Schaltungsanordnung 220' Teil eines Eingangsgerätes 200', insbesondere eines sicheren Eingangsgerätes, und die zweite Schaltungsanordnung 210' Teil eines zu diesem Eingangsgerät parallel geschalteten zweiten Gerätes, im dargestellten Fall Teil einer Diagnoseklemme.

Während bei einer Ausführungsform nach Fig. 1 bevorzugt eine gemeinsame Logikeinrichtung als Logikvorrichtung 230 vorgesehen ist, umfasst eine Ausführungsform nach Fig. 2 zweckmäßig wenigstens zwei Logikeinrichtungen 230' und 213 als Logikvorrichtung, wobei eine erste Logikeinrichtung 230' mit dem Schaltungsausgang der ersten Schaltungsanordnung und eine zweite Logikeinrichtung 213 mit dem Schaltungsausgang der zweiten Schaltungsanordnung verbunden ist.

Wie den Ausführungsformen nach Fig. 1 und 2 zu entnehmen, weist dort das OSSD_Ausgangsschaltelement 100 in vereinfachter Skizze einen OSSD-Ausgang 110 für ein OSSD-Ausgangssignal "sOUT" auf sowie einen OSSD-Ausgang 120 für Masseanschluss "GND".

Als erste Schaltungsanordnung, welche mit deren Schaltungseingang an den OSSD-Ausgang 110 und 120 des OSSD-Ausgangsschaltelement 100 anzuschalten ist kann vorteilhaft grundsätzlich jede digitale Eingangsschaltung eingesetzt werden, die zur Erfassung von Eingangssignalen geeignet ist, bzw. die innerhalb eines sicheren Eingangsgerätes zur Erfassung von sicheren Eingangssignalen geeignet ist. Wie bereits aufgezeigt, ist die Aufgabe dieser ersten Schaltungsanordnung 220, 220' ist, die vom OSSD-Ausgang 110 kommenden Signale statisch zu erfassen. Die dynamischen Anteile dieser Signale können innerhalb der erfindungsgemäßen Vorrichtung entweder durch die Auslegung der Filtereinrichtung in der Hardware dieser ersten Schaltungsanordnung 220, 220' oder in der Firmware der Logikvorrichtung 200 bzw. der Logikeinrichtung 230' ausgefiltert werden. Die Filterzeit ist hierbei zweckmäßig parametrierbar, um eine hohe Flexibilität zu erreichen.

Gemäß den Figuren weist die innerhalb des Eingangsgeräts 200 integrierte erste Schaltungsanordnung 220 als Filtereinrichtung zweckmäßig zunächst einen Spannungsteiler auf, der im dargestellten Fall aus zwei Widerständen R1 und R2 gebildet ist. Nach Anschalten der ersten Schaltungsanordnung 220 bzw. 220' mit deren Schaltungseingang an den Ausgang 110, 120 des OSSD-Ausgangsschaltelements 100 ist der Widerstand R1 ferner mit dem OSSD-Ausgang 110 und der Widerstand R2 ferner mit dem OSSD-Ausgang 120 verbunden. Zum Ausfiltern der dynamischen Signalanteile ist ein Kondensator C1 vorgesehen, der innerhalb der ersten Schaltungsanordnung 220 zwischen dem OSSD-Ausgang 110 und dem OSSD-Ausgang 120 angeordnet ist. Im Fall des obigen Spanungsteilers ist der Kondensator C1 somit zweckmäßig parallel zum Widerstand R2 geschaltet. Dem Kondensator C1 bzw. dem Widerstand R2 und dem Kondensator C1 ist wiederum parallel ein Optokoppler IC1 geschaltet, derart, dass eine auf der Eingangsseite des Optokopplers IC1 befindliche Leuchtdiode mit dem über den Spannungsteiler angepassten Signal angesteuert wird, wobei über den Kondensator C1 dynamischen Signalanteile ausgefiltert sind und die statischen Signalanteile zur weiteren Verwendung ausgekoppelt werden. Über den Spannungsteiler kann somit eine Signalanpassung der von dem OSSD-Ausgangsschaltelement 100 kommenden Signale für den Optokoppler IC1 vorgenommen werden. Am Ausgang des Optokopplers IC1 können dann mit Hilfe einer Gleichspannung von z.B. 3.3V und einem mit Masse "L_GND" verbundenen Abschlusswiderstand R3, parallel zum Widerstand R3 Signale abgegriffen werden, welche den statischen Signalanteilen von den Signalen entsprechen, die von dem OSSD-Ausgangsschaltelement 100 kommen. An diesem Abgreifpunkt "S" ist daher die Logikvorrichtung 230 gemäß Fig. 1 oder die Logikeinrichtung 230' parallel zum Widerstand R3 angeschaltet, so dass die abgegriffenen Signale an die zur weiteren Auswertung übertragen werden.

Auch die zweite Schaltungsanordnung 210 oder 210' als Filtereinrichtung zweckmäßig zunächst einen Spannungsteiler auf, der im dargestellten Fall aus zwei Widerständen R4 und R5 gebildet ist. Nach Anschalten der zweiten Schaltungsanordnung 210 bzw. 210' mit deren Schaltungseingang an den Ausgang 110, 120 des OSSD-Ausgangsschaltelements 100 ist der Widerstand R4 somit ferner mit dem OSSD-Ausgang 110 und der Widerstand R5 somit ferner mit dem OSSD-Ausgang 120 verbunden. Zum Ausfiltern der statischen Signalanteile weist die Filtereinrichtung der zweiten Schaltungsanordnung 210 bzw. 210' einen Kondensator C2 auf, der somit zweckmäßig zwischen dem Widerstand R4 und dem Widerstand R5 geschaltet ist, sowie einen Optokoppler IC2 zur Übertragung von dynamischen Signalanteilen in Richtung der Logikvorrichtung, Eine auf der Eingangsseite des Optokopplers IC2 befindliche Leuchtdiode ist im Signalpfad des Kondensators C2 diesem nachgeschaltet und also gemäß Figuren auch parallel zum Widerstand R5 geschaltet, derart also, dass die auf der Eingangsseite des Optokopplers IC2 befindliche Leuchtdiode mit dem über den Spannungsteiler angepassten Signal angesteuert wird, wobei über den Kondensator C2 die statischen Signalanteile ausgefiltert sind und die dynamischen Signalanteile zur weiteren Verwendung ausgekoppelt werden. Über den Spannungsteiler kann somit eine Signalanpassung der von dem OSSD-Ausgangsschaltelement 100 kommenden Signale für den Optokoppler IC2 vorgenommen werden. Am Ausgang des Optokopplers IC2 können dann mit Hilfe einer Gleichspannung von z.B. 3.3V und einem mit Masse "L_GND" verbundenen Abschlusswiderstand R6, parallel zum Widerstand R6 Signale abgegriffen werden, welche den dynamischen Signalanteilen von den Signalen entsprechen, die von dem OSSD-Ausgangsschaltelement 100 kommen. An diesem Abgreifpunkt "D" ist daher ein weiterführender Signalpfad zur Logikvorrichtung 230 (Fig. 1) oder die Logikeinrichtung 213 (Fig. 2) parallel zum Widerstand R6 angeschaltet, so dass die abgegriffenen Signale an diese zur weiteren Auswertung übertragen werden. Zweckmäßig ist ferner zwischen dem Optokoppler IC2 und der Logikvorrichtung 230 (Fig. 1) oder der Logikeinrichtung 213 (Fig. 2) eine Signalanpassungseinrichtung angeordnet, die zur zusätzlichen Signalanpassung der von dem Optokoppler IC2 erhaltenen Signale ausgebildet ist. Diese Signalanpassungseinrichtung besitzt gemäß Figuren den Widerstand R6 und einen in dem Signalpfad vom Abgreifpunkt "D" zur Logikvorrichtung 230 (Fig. 1) oder zur Logikeinrichtung 213 (Fig. 2) angeordneten Widerstand R7. Ferner ist ausgehend vom Signalpfad zwischen dem Widerstand R7 und der Logikvorrichtung 230 (Fig. 1) oder der Logikeinrichtung 213 (Fig. 2) ein Kondensator C3 an Masse "L_GND" geschaltet.

Über die aus den Widerständen R6 und R7 sowie dem Kondensator C3 aufgebaute Signalanpassungseinrichtung können die abgegriffenen Signale an die jeweilige spezifische innere Struktur der Logikvorrichtung 230 (Fig. 1) oder der Logikeinrichtung 213 angepasst werden und z.B. eine Verlängerung von Testimpulse zur vereinfachten Erfassung durch die Gerätefirmware und/oder eine Verbesserung des EMV-Verhaltens eingestellt werden. Insbesondere kann also die Impulsdauer an die Verarbeitungsgeschwindigkeit der Logikvorrichtung 230 (Fig. 1) oder der Logikeinrichtung 213 angepasst werden.

In der Logikvorrichtung 230 bzw. den Logikeinrichtungen 230` und 213 erfolgt sodann die Auswertung der statischen als auch der dynamischen Signalanteil und die Information für die weitere Verarbeitung, z.B. in einer nicht dargestellten, über ein Netzwerk mit der Logikvorrichtung 230 verbundenen Sicherheitssteuerung, wird entsprechend aufbereitet.

Gemäß Ausführungsform nach Fig. 1 führt die Logikvorrichtung hierbei zweckmäßig auch einen Vergleich anhand der statischen und dynamischen Signalanteile durch.

Die Ausführungsform nach Fig. 1 stellt somit bereits eine kostengünstige und nur noch wenige Bauteile erfordernde Vorrichtung nach der Erfindung bereit. Wie vorstehend aufgezeigt, kann gemäß Ausführungsform nach Fig. 2 die zweite Schaltungsanordnung 210' auch als Teil eines parallel geschalteten, zweiten Gerätes, im dargestellten Fall Teil einer Diagnoseklemme, realisiert sein. In diesem Fall ist zweckmäßig bevorzugt ein weiterer Meldeausgang, bei Fig. 2 als Diagnoseausgang bezeichnet, in Bezug auf das parallel geschaltete zweite Gerät vorgesehen. Im Fall des Ausbleibens von Testimpulsen von den OSSD-Ausgängen wird dann ein Diagnoseausgang aktiviert, wobei ein aktivierter Diagnoseausgang bevorzugt Low-aktiv sein sollte, der z.B. auch in der Sicherheitssteuerung ausgewertet wird. Mit der Verwendung eines solchen zweiten Gerätes kann zum Einen die Notwendigkeit einer sicheren Kabelverlegung auf eine einfache Art und Weise vermieden werden, andererseits kann ein solches zweites Gerät sich selbst aus dem OSSD-Ausgang 110, 120 mit Energie versorgen, was den Verkabelungsaufwand noch weiter reduziert und kann sehr einfach auch nachträglich, d.h. an entsprechenden Stellen innerhalb einer gegebenen Applikation, installiert werden ohne eine Sicherheitsfunktion zu beeinflussen.

Die gemäß Erfindung vorgeschlagene Lösung, welche vorstehend unter Bezugnahme auf die zwei bevorzugten Ausführungsformen nach Fig. 1 und 2 beschrieben ist, ermöglicht somit eine Entkopplung von Testimpulse von OSSD-Ausgängen 110, 120 zur Erfassung des Signalzustandes, insbesondere auch am Eingang eines sicheren Eingangsgeräts; die Ausfilterung von OSSD-Impulsen zur statistischen Signalerfassung; die Erfassung des Signalzustandes in einem Eingangsgerät; das Auskoppeln von Testimpulsen und Aufbereiten zur dynamischen Erfassung von Testimpulsen der OSSD-Ausgänge in einem Eingangsgerät; die Erfassung von Testimpulsen der OSSD-Ausgänge für die Diagnose der Verkabelung; eine vorgebbare, insbesondere einstellbare Filterzeit zur Ausfilterung von OSSD-Impulsen zur Erfassung der Signalzustände, insbesondere auch am Eingang eines sicheren Eingangsgeräts; eine Anpassung von OSSD-Impulsen zur dynamischen Erfassung für eine Verkabelungsdiagnose an die Verarbeitungsgeschwindigkeit einer nachfolgenden Logikvorrichtung; eine vorgebbare, insbesondere einstellbare Erwartungshaltung zur Häufigkeit von OSSD-Impulsen und eine vorgebbare, insbesondere einstellbare Erwartungshaltung zur Impulsdauer von OSSD-Impulsen.

Hierdurch kann eine Überwachung der Verkabelung durchgeführt werden, ohne dass spezielle Testimpulse von einem Eingangsgerät erforderlich sind. Falls die Überwachung der Verkabelung im Eingangsgerät in der Applikation zwingen erfordert ist, wäre es in einer Standardlösung nur mittels kontaktbehafteter Entkopplung der OSSD-Ausgänge vom Eingangsgerät, z.B. mittels eines Sicherheitsrelais, und Verwendung zusätzlicher Test- bzw. Taktausgänge des Eingangsgerätes möglich. Bei Verwendung der vorgeschlagenen Lösung nach der Erfindung kann diese Entkopplung entfallen, da eine Querschlussüberwachung durch die dynamische Erfassung von OSSD-Impulsen gewährleistet werden kann.

Ferner können sehr schnelle OSSD-Impulse, z.B. bei Lichtschranken im *µ*s Bereich, unabhängig von der statischen Signalerfassung kostengünstig überwacht werden und erfordern keine sehr schnelle Schaltungsanordnung oder Logikverarbeitung, die schnell genug sind, um die kurzen Testimpulse zu erfassen, da die zweite Schaltungsanordnung durch Dimensionierung der ausgangsseitig zum Optokoppler IC angeordneten Signalanpassungseinrichtung, gemäß Fig. 1 und 2 durch Dimensionierung der Bauteile R6, R7 und C3, an die Verarbeitungsgeschwindigkeit der Logik angepasst werden kann.

Ferner wird durch die Erfassung der dynamischen Signalanteile auch das Verhalten der OSSD-Ausgänge mit überwacht. Bleiben z.B. die Impulse bei dauerhaftem High-Signal aus, spricht dies für einen Querschluss auf 24V oder für einen defekten OSSD-Ausgang. Diese Überwachung wäre mit einer Standardschaltung nicht möglich, was ein Sicherheitsrisiko darstellt.

Ferner besteht eine flexible Anpassungsfähigkeit in Eingangsgerät gegeben, da die Möglichkeit einer Parametrierung der Erwartungshaltung an die Häufigkeit und Dauer von Testimpulse der OSSD-Ausgänge gegeben ist.

Darüber hinaus besteht die Möglichkeit einer vorgebbaren, insbesondere einstellbaren Filterzeit zur Ausfilterung von OSSD-Impulse zur Erfassung der Signalzustände, insbesondere auch am Eingang eines sicheren Eingangsgeräts.

Auch ist im Falle eines Eingangsgerätes auch weiterhin ein normaler Betrieb mit anderen Sensoren, wie z.B. Schalter möglich, wofür zweckmäßig die Testausgänge (in den Figuren nicht dargestellt) des Eingangsgerätes verwendet werden.

Mit der gemäß Erfindung vorgeschlagenen Lösung kann folglich die Dynamik auf einer Leitung überwacht und mit der statischen Auswertung des Zustandes kombiniert werden, so dass im Wesentlichen alle Fehler in der Verkabelung abgedeckt werden können.

### Bezugszeichen:

- 100: OSSD-Ausgangsschaltelement
- 110: OSSD-Ausgang für OSSD-Ausgangssignal "sOUT"
- 120: OSSD-Ausgang für Masseanschluss "GND"
- 200, 200': Eingangsgerät
- 210, 210': zweite Schaltungsanordnung; OSSD-Impuls Erfassungsschaltung
- 220, 220': erste Schaltungsanordnung; zustandserfassungsschaltung
- 230, 213, 230': Logikeinrichtungen
- S: Abgreifpunkt
- D: Abgreifpunkt

## Patentansprüche

1. Vorrichtung zur Auswertung von Signalen, die von einem OSSD-Ausgangsschaltelement ("OSSD", Output Signal Switching Device; 100) über eine Verkabelung kommen, umfassend:
- eine erste Schaltungsanordnung (220, 220'), welche mit deren Schaltungseingang an den Ausgang des OSSD-Ausgangsschaltelementes (100) anzuschalten ist, wobei die erste Schaltungsanordnung (220, 220') eine erste Filtereinrichtung für die Signale besitzt, die ausgebildet ist, statische Signalanteile zu erfassen und dynamische Signalanteile auszufiltern, und
- eine zweite Schaltungsanordnung (210, 210'), welche mit deren Schaltungseingang parallel zur ersten Schaltungsanordnung (220, 220') gleichermaßen an den Ausgang des OSSD-Ausgangsschaltelement (100) anzuschalten ist, wobei die zweite Schaltungsanordnung (210, 210') eine zweite Filtereinrichtung für die Signale besitzt, die ausgebildet ist, dynamische Signalanteile zu erfassen und statische Signalanteile auszufiltern, und
- eine Logikvorrichtung (230, 230',213), wobei der Schaltungsausgang der ersten Schaltungsanordnung und der Schaltungsausgang der zweiten Schaltungsanordnung mit der Logikvorrichtung verbunden ist, die ausgebildet ist, die von der ersten Schaltungsanordnung erfassten statischen Signalanteile und die von der zweiten Schaltungsanordnung erfassten dynamischen Signalanteile für eine Diagnose der Verkabelung auszuwerten,
wobei die erste Schaltungsanordnung (220, 220') Teil eines Eingangsgerätes (200, 200') und
die zweite Schaltungsanordnung (210, 210') Teil eines zum Eingangsgerät (200, 200') parallel geschalten zweiten Gerätes ist, sowie einen Kondensator (C2) zum Ausfiltern der statischen Signalanteile und einen Optokoppler (IC2) zur Übertragung von dynamischen Signalanteilen in Richtung der Logikvorrichtung (230) besitzt.

2. Vorrichtung nach Anspruch 1, **dadurch gekennzeichnet, dass** die Filtereinrichtung der ersten Schaltungsanordnung (220, 220') aus Hardwareelementen aufgebaut ist oder softwarebasiert aufgebaut ist.

3. Vorrichtung nach Anspruch 1 oder 2, **dadurch gekennzeichnet, dass** die zweite Schaltungsanordnung (210, 210') einen Spannungsteiler zur Signalanpassung eines am Schaltungseingang der zweiten Schaltungsanordnung (210, 210') anliegenden Signals besitzt.

4. Vorrichtung nach einem der Ansprüche 1 bis 3, **dadurch gekennzeichnet, dass** die zweite Schaltungsanordnung (210, 210') zwischen dem Optokoppler und der Logikvorrichtung (230) eine Signalanpassungseinrichtung besitzt, die zur Signalanpassung eines von dem Optokoppler erhaltenen Signals ausgebildet ist.

5. Vorrichtung nach einem der vorstehenden Ansprüche 1 bis 4, **dadurch gekennzeichnet, dass** die Logikvorrichtung (230) wenigstens zwei Logikeinrichtungen (230', 213) umfasst, wobei eine erste Logikeinrichtung (230') mit dem Schaltungsausgang der ersten Schaltungsanordnung (220, 220') und eine zweite Logikeinrichtung (213) mit dem Schaltungsausgang der zweiten Schaltungsanordnung (210, 210') verbunden ist.

6. Vorrichtung nach einem der Ansprüche 1 bis 5, **dadurch gekennzeichnet, dass** sich das zum Eingangsgerät (200, 200') parallel geschaltete zweite Gerät, aus den von dem Ausgang des OSSD-Ausgangsschaltelements (100) kommenden Signalen mit Energie versorgt.

7. Vorrichtung nach einem der Ansprüche 1 bis 6, **dadurch gekennzeichnet, dass** in Bezug auf das parallel geschaltete zweite Gerät ein Diagnoseausgang vorgesehen ist, der im Fall des Ausbleibens von Testimpulsen von den OSSD-Ausgängen aktivierbar ist.

## Claims

1. Device for the evaluation of signals originated by an OSSD output switching element ("OSSD", Output Signal Switching Device; 100) via a cabling, comprising:
- a first circuit arrangement (220, 220'), the circuit input of which is to be connected to the output of the OSSD output switching element (100),
wherein the first circuit arrangement (220, 220') has a first filter device for the signals, which is designed to detect static signal components and to filter out dynamic signal components, and
- a second circuit arrangement (210, 210'), the circuit input of which is to be connected in parallel with the first circuit arrangement (220, 220') equally to the output of the OSSD output switching element (100), wherein the second circuit arrangement (210, 210') has a second filter device for the signals, which is designed to detect dynamic signal components and filter out static signal components, and
- a logic device (230, 230', 213), wherein the circuit output of the first circuit arrangement and the circuit output of the second circuit arrangement are connected to the logic device, which is designed to evaluate the static signal components detected by the first circuit arrangement and the dynamic signal components detected by the second circuit arrangement for a diagnosis of the cabling,
wherein the first circuit arrangement (220, 220') is part of an input device (200, 200') and the second circuit arrangement (210, 210') is part of a second device connected in parallel with the input device (200, 200') and has a capacitor (C2) for filtering out the static signal components and an optocoupler (IC2) for the transmission of dynamic signal components in the direction of the logic device (230).

2. Device according to claim 1, **characterized in that** the filter device of the first circuit arrangement (220, 220') is constructed from hardware elements or is software-based.

3. Device according to claim 1 or 2, **characterized in that** the second circuit arrangement (210, 210') has a voltage divider for signal adaptation of a signal applied to the circuit input of the second circuit arrangement (210, 210').

4. Device according to any one of claims 1 to 3, **characterized in that** the second circuit arrangement (210, 210') has a signal matching device between the optocoupler and the logic device (230), which is designed for signal adaptation of a signal received from the optocoupler.

5. Device according to one of the preceding claims 1 to 4, **characterized in that** the logic device (230) comprises at least two logic devices (230', 213), wherein a first logic device (230') is connected to the circuit output of the first circuit arrangement (220, 220') and a second logic device (213) is connected to the circuit output of the second circuit arrangement (210, 210').

6. Device according to one of claims 1 to 5, **characterized in that** the second device connected in parallel to the input device (200, 200') supplies itself with energy from the signals coming from the output of the OSSD output switching element (100).

7. Device according to one of claims 1 to 6, **characterized in that** a diagnostic output is provided in relation to the second device connected in parallel, which diagnostic output can be activated in the event of the absence of test pulses from the OSSD outputs.

## Revendications

1. Dispositif d'évaluation de signaux, qui proviennent, au moyen d'un câblage, d'un élément de commutation de sortie OSSD (« OSSD », Output Signal Switching Device-dispositif de commutation du signal de sortie ; 100), comprenant :
- un premier ensemble de circuits (220, 220'), lequel est destiné à être connecté à l'aide de son entrée de circuit à la sortie de l'élément de commutation de sortie OSSD (100), dans lequel le premier ensemble de circuits (220, 220') comporte un premier système filtre pour les signaux, qui est conçu pour détecter les composantes statiques de signal et pour filtrer les composantes dynamiques de signal, et
- un second ensemble de circuits (210, 210'), lequel est destiné à être connecté à l'aide de son entrée de circuit, en parallèle au premier ensemble de circuits (220, 220'), de la même manière à la sortie de l'élément de commutation de sortie OSSD (100), dans lequel le second ensemble de circuits (210, 210') comporte un second système filtre pour les signaux, qui est conçu pour détecter les composantes dynamiques de signal et pour filtrer les composantes statiques de signal, et
- un dispositif logique (230, 230', 213), dans lequel la sortie de circuit du premier ensemble de circuits et la sortie de circuit du second ensemble de circuits sont raccordées au dispositif logique, qui est conçu pour évaluer les composantes statiques de signal détectées par le premier ensemble de circuits et les composantes dynamiques de signal détectées par le second ensemble de circuits pour un diagnostic du câblage.
dans lequel le premier ensemble de circuits (220, 220') fait partie d'un appareil d'entrée (200, 200') et
le second ensemble de circuits (210, 210') fait partie d'un second appareil connecté en parallèle à l'appareil d'entrée (200, 200'), et comporte aussi un condensateur (C2) pour filtrer les composantes statiques de signal et un optocoupleur (IC2) pour transmettre les composantes dynamiques de signal dans la direction du dispositif logique (230).

2. Dispositif selon la revendication 1, **caractérisé en ce que** le système filtre du premier ensemble de circuits (220, 220') est construit à partir d'éléments matériels ou est construit sur la base d'un logiciel.

3. Dispositif selon la revendication 1 ou 2, **caractérisé en ce que** le second ensemble de circuits (210, 210') comporte un diviseur de tension permettant l'adaptation de signal d'un signal appliqué à l'entrée de circuit du second ensemble de circuits (210, 210').

4. Dispositif selon l'une quelconque des revendications 1 à 3, **caractérisé en ce que** le second ensemble de circuits (210, 210') comporte entre l'optocoupleur et le dispositif logique (230) un système d'adaptation de signal, qui est conçu pour l'adaptation de signal d'un signal reçu de l'optocoupleur.

5. Dispositif selon l'une quelconque des revendications précédentes 1 à 4, **caractérisé en ce que** le dispositif logique (230) comprend au moins deux systèmes logiques (230', 213), dans lequel un premier système logique (230') est raccordé à la sortie de circuit du premier ensemble de circuits (220, 220') et un second système logique (213) est raccordé à la sortie de circuit du second ensemble de circuits (210, 210').

6. Dispositif selon l'une quelconque des revendications 1 à 5, **caractérisé en ce que** le second appareil connecté en parallèle à l'appareil d'entrée (200, 200') est alimenté en énergie à partir des signaux provenant de la sortie de l'élément de commutation de sortie OSSD (100).

7. Dispositif selon l'une quelconque des revendications 1 à 6, **caractérisé en ce que**, par rapport au second appareil connecté en parallèle, une sortie de diagnostic est prévue, qui peut être activée en cas d'absence des impulsions d'essai provenant des sorties OSSD.
